# EUROPÄISCHE PATENTANMELDUNG

(11) **EP 0 591 939 A2**
(43) Veröffentlichungstag der Anmeldung: **13.04.1994**
(21) Anmeldenummer: 93116140.0
(22) Anmeldetag: 06.10.1993
(51) Int. Cl.: H01L 21/335, H01L 29/76, H01L 21/265

(54) **Verfahren zur Herstellung von Feldeffekt-Transistoren**

(30) Priorität: 07.10.1992 DE 4233766
(71) Anmelder: FRAUNHOFER-GESELLSCHAFT ZUR FÖRDERUNG DER ANGEWANDTEN FORSCHUNG E.V., D-80636 München (DE)
(72) Erfinder: Hülsmann, Axel, D-79104 Freiburg (DE)

(57) **Zusammenfassung**

Zur vereinfachten Herstellung von III-V-Halbleiter-Feldeffekttransistoren ist vorgesehen, daß auf der Oberfläche einer auf einem Substrat (1) aufgebrachten Heteroschicht (2) zuerst ein T-förmiges Gate (5) lithographisch aufgebracht wird. In einem folgenden Lithographieschritt wird eine das jeweilige Transistorelement umgrenzende Maske auf der Heteroschicht (2) aufgebracht. Der jeweilige den Quersteg (5a) des T-förmigen Gates (5) etwa umgrenzende und von der Maske freigelassene Bereich der Heteroschicht (2) sowie die Oberseite des Quersteges (5a) des T-förmigen Gates (5) werden dann mit einem Metalldampfstrahl zur Bildung von Source (3) und Drain (4) beidseits des von dem Quersteg (5a) abgeschatteten Bereiches bedampft. In einem dritten Prozeßschritt werden ohne Lithographie die zwischen den jeweiligen Transistorelementen liegenden Bereiche (10) durch Ionenimplantation elektrisch isolierend gemacht. Durch dieses Verfahren wird ein Lithographieschritt eingespart und durch die andere Reihenfolge der Prozeßschritte wird eine aufwendige Zentrierung des Gates (5) zwischen Source (3) und Drain (4) vermieden.

## Beschreibung

Die Erfindung betrifft ein Verfahren zur Herstellung von Feldeffekttransistoren auf III-V-Halbleiter-, insbesondere Galliumarsenid- oder Indiumphosphid-Basis mit mehreren Lithographieschritten, wobei auf einem semiisolierenden Substrat eine dotierte Heteroschicht epitaktisch aufgebracht wird, auf der Oberfläche dieser Heteroschicht jeweils zu einem Transistorelement gehörende Gate-, Source- und Drain-Kontakte angeordnet werden, wobei jeweils ein Gate durch einen im Querschnitt T-förmigen Schottkykontakt und Source beziehungsweise Drain durch ohmsche Kontaktschichten hergestellt werden, wobei weiterhin jeweils ein Transistorelement umgrenzende und die Heteroschicht durchsetzende elektrisch isolierende Isolations-Bereiche durch Ionenimplantation dieser Bereiche gebildet werden.

Bei diesem bekannten Herstellungsverfahren tragen die erforderlichen Lithographieschritte erheblich zu den Herstellungskosten bei. Dabei sind drei Lithographieschritte erforderlich, so daß das Herstellungsverfahren vergleichsweise aufwendig und teuer ist. Weiterhin ist nachteilig, daß beim Aufbringen des Gates auf die Heteroschicht das Gate exakt zwischen Source und Drain positioniert werden muß und daß dazu ein zeitaufwendiges Justiermarkensuchen notwendig ist.
Es sind auch schon aus der Druckschrift IEE Tr.o.E1. Dev., Vol.37, No. 4, Apr.1990, pp 935-841 sowie der EP 523 731 Herstellungsverfahren bekannt, bei denen eine Selbstjustierung von Source und Drain erreicht wird.
Diese selbstjustierenden Implantations-Prozesse zur Herstellung von MOD-FETs sind auch unter der Abkürzung SAINT (Self Aligned Implantation for n-layer Technology) bekannt. Bei dem Herstellungsprozeß wird auf der SiON passivierten HEMT-Struktur ein Dummy-Gate hergestellt, das zur Maskierung der selbstjustierenden Source-Drain-Implantation verwendet wird. Anschließend maskiert das Dummy-Gate ein aufgedampftes, hochtemperaturstabiles Dielektrikum (z.B. Siliciumoxyd). Nach dem Lift-Off hinterläßt das Dummy-Gate eine Lücke im Dielektrikum zwischen Source und Drain, die nicht implantiert wurde. Für das Ausheilen der Strahlenschäden und die Aktivierung der Dotierung muß dann eine an sich nachteilige Hochtemperaturbehandlung bei etwa 1000°C durchgeführt werden. Durch eine weitere Lackmaske zur Definition von Source und Drain werden Kontaktlöcher geätzt und das Ohm-Metall aufgedampft. Die Ohm-Kontakte werden bei einer Temperatur um 400°C legiert. Vor dem Aufdampfen des Gatemetalls aus Ti/Pt/Au wird die SiON-Passivierung im Gatebereich entfernt. Die Position und Geometrie des Schottky-Kontaktes wurde bereits durch das Dummy-Gate festgelegt. Die Maske für das Gatemetall muß mindestens um die Justiergenauigkeit größer sein als die des Dummy-Gates.
Weiterhin kennt man aus der Druckschrift "FABRICATION OF A 80 nm SELF-ALIGNED T-GATE A1InAs/GaInAs HEMT" ein Herstellungsverfahren für Feldeffekttransistoren ebenfalls mit selbstjustiertem T-Gate. Bei diesem Herstellungsprozeß wird nach einem ersten Lithographieschritt eine Mesa-Ätzung vorgenommen. Mesa-Ätzungen haben den Nachteil, daß große Topographiestufen die Verdrahtung erschweren und die Integrierbarkeit begrenzen. In einem nächsten Lithographieschritt wird dann eine weitere Maske zur Bildung des T-Gates aufgebracht und das T-Gate durch Metallaufdampfen gebildet. Im nächsten, dritten Lithographieschritt erfolgt dann eine Abgrenzung der Source- und Drain-Gebiete. Anschließend erfolgt durch Metallaufdampfen selbstjustierend das Herstellen von Source und Drain.
Auch hierbei sind drei Lithographieschritte erforderlich und somit das Herstellungsverfahren insgesamt vergleichsweise aufwendig.

Es besteht daher die Aufgabe, ein Verfahren der eingangs erwähnten Art zu schaffen, durch das die Herstellung vereinfacht und kostengünstiger durchgeführt werden kann, wobei aber die exakte geometrische Zuordnung der Source-, Drain- und Gate-Kontakte zumindest beibehalten bleibt. Außerdem sollen die elektrischen Eigenschaften der danach hergestellten Feldeffekttransistoren verbessert werden.

Zur Lösung dieser Aufgabe wird erfindungsgemäß vorgeschlagen, daß auf der Oberfläche der Heteroschicht zuerst das T-förmige Gate lithographisch aufgebracht wird, daß in einem folgenden Lithographieschritt eine das jeweilige Transistorelement umgrenzende Maske auf der Heteroschicht aufgebracht wird und der jeweilige den Quersteg des T-förmigen Gates etwa umgrenzende und von der Maske freigelassene Bereich der Heteroschicht sowie die Oberseite des Quersteges des T-förmigen Gates mit einem Metalldampfstrahl zur Bildung von Source und Drain beidseits des von dem T-Quersteg abgeschatteten Bereiches beaufschlagt beziehungsweise bedampft wird, und daß in einem weiteren Prozeßschritt die zwischen den jeweiligen Transistorelementen liegenden Bereiche durch Ionenimplantationsbeschuß elektrisch isolierend gemacht werden, wobei der Bereich von Gate, Source und Drain auf der Heteroschicht durch diese Zonen abschattende Kontaktierungsschichten geschützt werden.

Bei diesem Verfahren wird zuerst das T-förmige Gate erzeugt, so daß in einem nächsten Prozeßschritt beim Aufbringen von Source und Drain beidseits vom T-förmigen Gate abgeschattete Bereiche vorhanden sind. Das T-förmige Gate dient dabei praktisch als Maske, um Source und Drain voneinander zu trennen. Dadurch ist der Abstand zwischen Source und Gate beziehungsweise Gate und Drain selbstjustierend definiert. Ein Justieren von Source und Drain relativ zum Gate erübrigt sich somit auch bei diesem Verfahren.
Weiterhin kann auch der Lithographieschritt bei der Erzeugung der Isolationsbereiche entfallen. Die auf das T-förmige Gate aufgedampfte Metall-Kontaktschicht wird nämlich durch das Aufdampfen nach oben hin breiter und verbreitert den Querschnitt des Gates, so daS bei der nachfolgenden Isolationsimplantation Gate, Source und Drain selbstmaskierend wirken.
Die erfindungsgemäße Prozeßführung mit Wegfall eines teuren Lithographieschrittes vereinfacht und verkürzt den Herstellungsprozeß und somit werden auch die Herstellungskosten ganz erheblich reduziert, was in Anbetracht der üblicherweise großen produzierten Stückzahlen einen erheblichen Wirtschaftsfaktor bedeutet.
Schließlich können durch das erfindungsgemäße Herstellungsverfahren sehr kleine Sourcewiderstände realisiert werden, da die Source- und Drain-Gebiete selbstjustierend zum Gate hergestellt werden. Dadurch steigt die extrinsische Steilheit der Feldeffekttransistoren und deren Grenzfrequenz.

Nach einer Weiterbildung der Erfindung kann es vorteilhaft sein, wenn der zwischen Gate und Drain befindliche Bereich der Heteroschicht bei der Isolationsimplantation zumindest bereichsweise mitbestrahlt wird. Durch die Ionenbestrahlung wird in diesem Bereich eine Ladungsträger-Verarmungszone erzeugt, wodurch dieser Bereich hochohmiger wird. Dadurch kann in erwünschter Weise eine Erhöhung der Durchbruchsspannung des Transistors erreicht werden.

Zweckmäßig ist es dabei, wenn bei der Isolationsimplantations-Bestrahlung des zwischen Gate und Drain befindlichen Bereiches der Heteroschicht die Strahlrichtung schräg zur Ebene der Heteroschicht verläuft und dabei der Bereich der Heteroschicht zwischen Source und Gate zumindest weitgehend abgeschattet ist und eine Seitenbegrenzung der Strahlung einerseits durch die dem Drainkontakt zugewandte Seite des T-förmigen Gates sowie der darauf befindlichen Metallbeschichtung und andererseits durch die dem Gate-Kontakt zugewandte Seite des Drainkontaktes erfolgt. Ohne besondere Zusatzmaßnahmen wird durch die schräge Strahlrichtung exakt nur der dafür vorgesehene Bereich bestrahlt und im Sinne einer Erhöhung der Durchbruchsspannung beeinflußt.
Nachstehend ist die Erfindung mit ihren ihr als wesentlich zugehörenden Einzelheiten anhand der Zeichnung noch näher beschrieben.
Es zeigt in schematischer Darstellung:
- Fig. 1: einen Teilausschnitt einer Substratschicht mit einer darauf befindlichen Heteroschicht, wobei während einer ersten Prozeßphase ein im Querschnitt T-förmiger Gate-Kontakt aufgebracht ist,
- Fig. 2: einen Teilausschnitt einer Substratschicht mit einer darauf befindlichen Heteroschicht etwa Fig.1 entsprechend, hier jedoch mit während einer zweiten Prozeßphase durch Aufdampfen aufgebrachten Source- und Drain-Kontaktschichten,
- Fig. 3: einen weiteren Teilausschnitt einer Substratschicht mit einer darauf befindlichen Heteroschicht etwa Fig.2 entsprechend, wobei hier während einer dritten Prozeßphase durch Ionenimplantation erzeugte, das Transistorelement umgrenzende Isolationsbereiche vorhanden sind und
- Fig. 4: einen Teilausschnitt einer Substratschicht mit einer darauf befindlichen Heteroschicht, wobei während der dritten, gegenüber Fig.3 abgewandelten Prozeßphase die Strahlrichtung der einfallenden Ionen schräg zur Oberfläche der Heteroschicht verläuft.

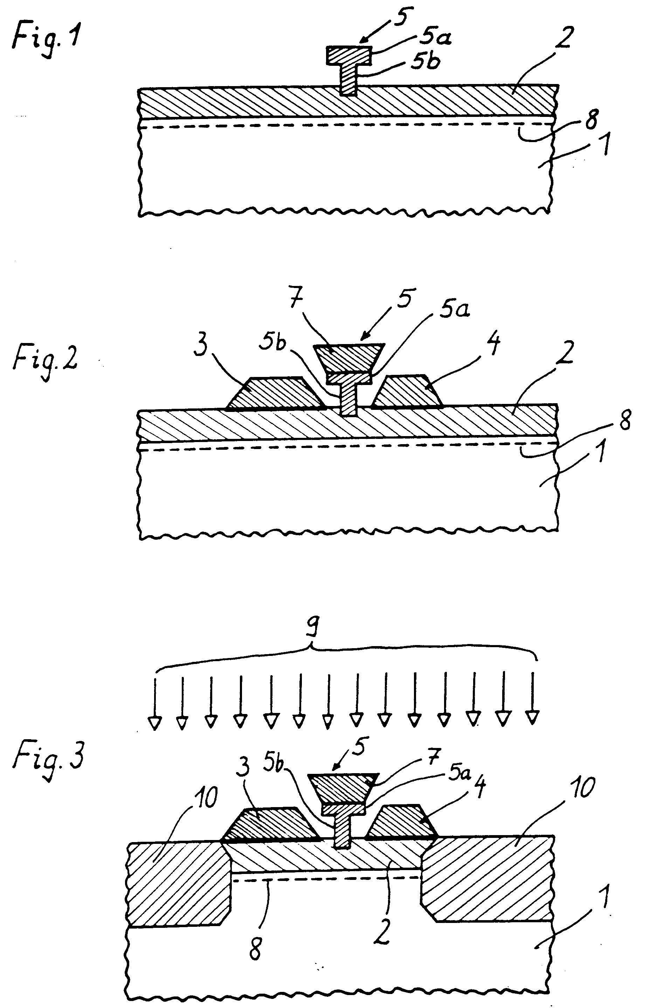

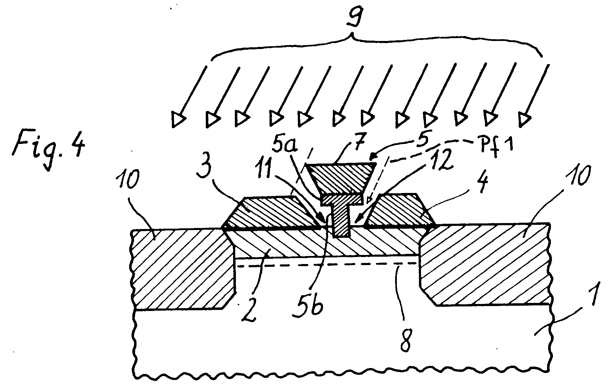

In Fig.1 bis 3 ist ein Teil eines sogenannten "Wafers" mit aufgebrachten Kontakten während verschiedener, aufeinanderfolgender Prozeßphasen zur Herstellung von Feldeffekt-Transistoren für Hochfrequenzanwendungen mit Arbeitsfrequenzen im Mikrowellenbereich gezeigt. Dazu werden sogenannte "III-V"-Halbleiterstoffe verwendet, das sind Verbindungshalbleiter, die sich aus Elementen der dritten und fünften Spalte des Periodensystems, wie zum Beispiel Galliumarsenid oder Indiumphosphid zusammensetzen.
Ein in Fig.3 gezeigter Feldeffekt-Transistor besteht im wesentlichen aus einem hochohmigen, semiisolierenden Substrat 1 mit einer darauf angebrachten, meist epitaktisch aufgewachsenen aktiven Schicht - der sogenannten Heteroschicht 2 - und daraufliegenden ohmschen Source- und Drain-Kontakten 3, 4 sowie einem dazwischen befindlichen Gate 5, welches als Schottky-Kontakt auf der Heteroschicht 2 angeordnet ist. Die Funktion dieses Bauelementes basiert auf dem unipolaren Transport von Majoritätsträgern im Halbleiterkristall, wobei der Leitwert eines zwischen Source und Drain 3,4 befindlichen Strompfades durch ein am Gate 5 angelegtes Spannungspotential gesteuert oder moduliert wird.
Im Ausführungsbeispiel besteht die Substratschicht 1 aus Galliumarsenid (GaAs) und die darauf epitaktisch aufgebrachte dotierte Heteroschicht 2 aus dem System Al(x)Ga(1-x)As/GaAs, wobei x das Stöchiometrieverhältnis angibt. Die Heteroschicht 2 läßt an der Grenzfläche zwischen Substrat 1 und Heteroschicht 2 ein hochbewegliches, zweidimensionales Elektronengas 8 entstehen.

Wie Fig.1 zeigt, wird in einem ersten Prozeßschritt auf der Oberfläche der Heteroschicht 2 zuerst das Gate lithographisch aufgebracht. Dabei wird die "T-Gate-Technologie" benutzt, d.h. ein Pilz- oder T-förmiger Querschnitt des Gates 5 wird mit Hilfe der Elektronenstrahllithographie auf der Oberfläche der Heteroschicht 2 erzeugt. Dabei ragt der Fuß des T-förmigen Gates 5 in die Heteroschicht 2 hinein. Das Gate 5 besteht aus einer Titan-Platin-Gold-Legierung.

In einem folgenden, zweiten Prozeßschritt (Fig.2) wird lithographisch eine Maske auf der Oberfläche der Heteroschicht 2 aufgebracht, die die für das Transistorelement vorgesehene Fläche mit dem darin verankerten Gate 5 umgrenzt. Der von der Maske freigelassene Bereich der Heteroschicht 2 sowie die Oberseite des Quersteges 5a des T-förmigen Gates werden dann von einem Metalldampfstrahl beaufschlagt. Der Strahl ist auf die Oberfläche der Heteroschicht 2 gerichtet, wobei ein beidseits an den Fuß 5b des Gates 5 angrenzender Bereich der Heteroschicht 2 wegen der Abschattung des Quersteges 5a des T-förmigen Gates 5 von dem Strahl praktisch unbedampft bleibt. Dadurch bilden sich durch Schichtwachstum auf der Heteroschicht 2 beidseits des Gatekontaktes zwei flächige Kontaktbereiche 3, 4 aus, die durch die - praktisch unbedampfte - Abschattungszone an ihren einander zugewandten Enden voneinander getrennt sind und außen durch die Lackmaske begrenzt sind. Die ebenfalls bedampfte Maske wird durch die sogenannte Abhebetechnik ("Lift off Technique") - durch Auflösen der Lackmaske in einem Lösungsmittel - mit der sie beaufschlagenden Metallschicht abgelöst. Dabei bleibt der von der Maske freigelassene, für das Transistorelement vorgesehene Bereich unbeeinflußt, d.h. in den fotolackfreien Bereichen bleibt das Metall auf der Heterooberfläche 2.
Die beiden durch die Abschattungszone mit dem darin verankerten Gate 5 getrennten Kontaktschichten dienen als Source- bzw. Drain-Kontakte 3 bzw. 4, die durch Verwendung einer Gold-Germanium-Nickel-Legierung bei der Bedampfung durch den Metalldampfstrahl ohmsche Übergänge zur Heteroschicht 2 bilden. Durch die Bedampfung bildet sich auch eine Metallschicht 7 auf der Oberfläche des Quersteges 5a des Gates 5. Die Metallschicht 7 verbreitert sich mit zunehmender Schichtdicke etwa trapezförmig und vergrößert die Breite des Quersteges 5a des Gates 5. Die Source- und Drain-Kontakte 3, 4 werden also bedingt durch den Abschattungseffekt des Gates 5 selbstjustierend positioniert, so daß sonst erforderliche, aufwendige Justierungen vermieden werden.
In einem dritten Prozeßschritt (Fig.3) wird die Oberfläche der Heteroschicht 2 mit dem darauf befindlichen Transistorelement - in der Regel sind es eine Vielzahl von benachbarten Transistorelementen - einem Ionenimplantationsbeschuß ausgesetzt. Die etwa rechtwinklig zur Heteroschicht 2 einfallende Ionenstrahlung 9 wird in dem Bereich des jeweiligen Transistorelementes durch die metallisch aufgedampften Kontakte 3, 4, 7 absorbiert. Der das Transistorelement umgrenzende Bereich 10 der Heteroschicht 2 ist dagegen ungeschützt und die einfallende Ionenstrahlung 9 dringt dort in diese Heteroschicht 2 und die darunter befindliche Substratschicht 1 ein. Wegen des dabei verursachten Strahlenschadens wird dieser Bereich 10 elektrisch isolierend. Der zwischen Source und Drain 3, 4 befindliche Teil der Heteroschicht 2 - die aktive Zone - wird durch die abschattende Wirkung des Gate-Quersteges 5a und der darauf befindlichen Kontaktierungsschicht 7 geschützt, da der Abstand Source-Drain bei diesem Verfahren durch die Breite des Gate-T-Quersteges 5a bestimmt ist. Im Ausführungsbeispiel liegen diese Dimensionen in der Größenordnung von etwa 1 Mikrometer und weniger. Ein besonderer Vorteil bei diesem Prozeßschritt besteht darin, daß keine aufwendige Lithographie erforderlich ist.

Bei einer abgewandelten Ausführungsform des dritten Prozeßschrittes ( Fig.4 ) verläuft die Strahlrichtung der Ionenstrahlung 9 schräg zur Ebene der Heteroschicht 2. Der Winkel der einfallenden Strahlung 9 bezüglich der Heteroschicht 2 ist dabei so gewählt, daß zwischen Gate 5 und Drain 4 ein Zutrittskanal (Pfeil Pf 1) gebildet ist, durch den die Ionenstrahlung 9 auf den zwischen Gate 5 und Drain 4 befindlichen Bereich 12 der Heteroschicht 2 auftreffen kann, während der zwischen Source 3 und Gate 5 befindliche Bereich 11 vom Gate 5 weitgehend abgeschattet wird. Dadurch wird der Bereich 12 zwischen Gate 5 und Drain 4 der Heteroschicht 2 durch Ionenimplantation hochohmiger als der Source-Gate-Bereich 11. Aufgrund des geringen Querschnittes des Zutrittskanals ist die Eindringtiefe der in den Gate-Drain-Bereich 5,4 einfallenden Ionenstrahlung 9 kleiner als die Dicke der Heteroschicht 2, so daß sich lediglich eine sog. Verarmungszone ("depletion zone") bildet, wodurch sich vorteilhaft die Durchbruchsspannung erhöht, ohne die Kanalleitfähigkeit des Transistorelementes zu beeinflussen. Der Zutrittskanal definiert für die auf die aktive Zone einfallende Ionenstrahlung 9 eine Seitenbegrenzung, die einerseits durch die dem Drainkontakt 4 zugewandte Seite des Gates 5 sowie der auf dem Quersteg 5a befindlichen Metallbeschichtung 7 und andererseits durch die dem Gate 5 zugewandte Seite des Drains 4 erfolgt. Auch bei dieser Ausführungsform werden ohne aufwendige Lithographie das Transistorelement umgrenzende Isolationsbereiche 10 erzeugt, deren Tiefe - wie in Fig.3 - größer als die Dicke der Heteroschicht 2 ist.

## Patentansprüche

1. Verfahren zur Herstellung von Feldeffekttransistoren auf III-V-Halbleiter-, insbesondere Galliumarsenid- oder Indiumphosphid-Basis mit mehreren Lithographieschritten, wobei auf einem semiisolierenden Substrat eine dotierte Heteroschicht epitaktisch aufgebracht wird, auf der Oberfläche dieser Heteroschicht jeweils zu einem Transistorelement gehörende Gate-, Source- und Drain-Kontakte angeordnet werden, wobei jeweils ein Gate durch einen im Querschnitt T-förmigen Schottkykontakt und Source beziehungsweise Drain durch ohmsche Kontaktschichten hergestellt werden, wobei weiterhin jeweils ein Transistorelement umgrenzende und die Heteroschicht durchsetzende elektrisch isolierende Isolations-Bereiche durch Ionenimplantation dieser Bereiche gebildet werden, **dadurch gekennzeichnet**, daß auf der Oberfläche der Heteroschicht (2) zuerst das T-förmige Gate (5) lithographisch aufgebracht wird, daß in einem folgenden Lithographieschritt eine das jeweilige Transistorelement umgrenzende Maske auf der Heteroschicht (2) aufgebracht wird und der jeweilige den Quersteg (5a) des T-förmigen Gates (5) etwa umgrenzende und von der Maske freigelassene Bereich der Heteroschicht (2) sowie die Oberseite des Quersteges (5a) des T-förmigen Gates (5) mit einem Metalldampfstrahl zur Bildung von Source (3) und Drain (4) beidseits des von dem T-förmigen Quersteg (5a) abgeschatteten Bereiches beaufschlagt beziehungsweise bedampft wird, und daß in einem weiteren Prozeßschritt die zwischen den jeweiligen Transistorelementen liegenden Bereiche (10) durch Ionenimplantationsbeschuß elektrisch isolierend gemacht werden, wobei der Bereich von Gate (5), Source (3) und Drain (4) auf der Heteroschicht (2) durch diese Zonen abschattende Kontaktierungsschichten geschützt werden.

2. Verfahren nach Anspruch 1, dadurch gekennzeichnet, daß der zwischen Gate (5) und Drain (4) befindliche Bereich der Heteroschicht (2) bei der Isolationsimplantation zumindest bereichsweise mitbestrahlt wird.

3. Verfahren nach Anspruch 2, dadurch gekennzeichnet, daß bei der Isolationsimplantations-Bestrahlung (9) des zwischen Gate (5) und Drain (4) befindlichen Bereiches der Heteroschicht (2) die Strahlrichtung (9) schräg zur Ebene der Heteroschicht (2) verläuft und dabei der Bereich der Heteroschicht (2) zwischen Source (3) und Gate (5) zumindest weitgehend abgeschattet ist und eine Seitenbegrenzung der Strahlung (9) einerseits durch die dem Drainkontakt (4) zugewandte Seite des T-förmigen Gates (5) sowie der darauf befindlichen Metallbeschichtung (7) und andererseits durch die dem Gate-Kontakt (5) zugewandte Seite des Drain-Kontaktes (4) erfolgt.
